# EUROPEAN PATENT APPLICATION

(11) **EP 1 376 113 A1**
(43) Date of publication of application: **02.01.2004**
(21) Application number: 02011036.7
(22) Date of filing: 17.05.2002
(51) Int. Cl.: G01N 27/22

(54) **Protective circuit for a supersonic humidifier**

(71) Applicant: Pan, Huang Chuan, Tainan City (TW); Lung, Huang Chen, Tainan City (TW)
(72) Inventor: Pan, Huang Chuan, Tainan City (TW); Lung, Huang Chen, Tainan City (TW)
(74) Representative: Dahnér, Christer

(57) **Abstract**

A protective circuit for a supersonic humidifier includes a compare circuit to obtain working voltage at two terminals of an oscillator to decide whether the humidifier is to be continued to operate or stopped so as to protect it from burning up. The protective circuit does not utilize a vibration needle, a float, a magnetic switch and a HALL IC used in conventional humidifiers.

## Description

### BACKGROUND OF THE INVENTION

This invention relates to a protective circuit for a supersonic humidifier, particularly to one utilizing a compare circuit to obtain working voltage at two terminals of an oscillator for deciding to turn off or continue to let a switch on so that the humidifier may be timely stopped in case of no water left in a water tank, without possibility of burning up.

Nowadays, conventional supersonic humidifiers all use a detective element in a water tank to detect if there is water in the water tank or not so that a supersonic oscillator should continue to operate or not with the power switch being on. In this way the humidifier may operate normally, protected from burning up in case of no water in the water tank.

However, the detective element such as a vibrating needle, a magnetic switch, a HALL IC in cooperation of a float occupies large dimensions, hardly applicable to a comparatively small humidifier. Besides, in case that water in the water tank is used up, or the float is placed upside down, the detecting element may detect erroneously to let the humidifier continue to operate, resulting in burning up.

### SUMMARY OF THE INVENTION

This invention has been devised to offer a protective circuit for a supersonic humidifier, which can produce compared signals for deciding whether the humidifier should continue to operate or to stop.

The feature of the invention is a drive circuit containing a compare circuit to obtain working current, working voltage and oscillating frequency (working value) at two terminals of an oscillator to decide to continue or stop operation of the humidifier so as to protect it from burning up.

### BRIEF DESCRIPTION OF A DRAWING

This invention will be better understood by referring to the accompanying drawing, wherein:

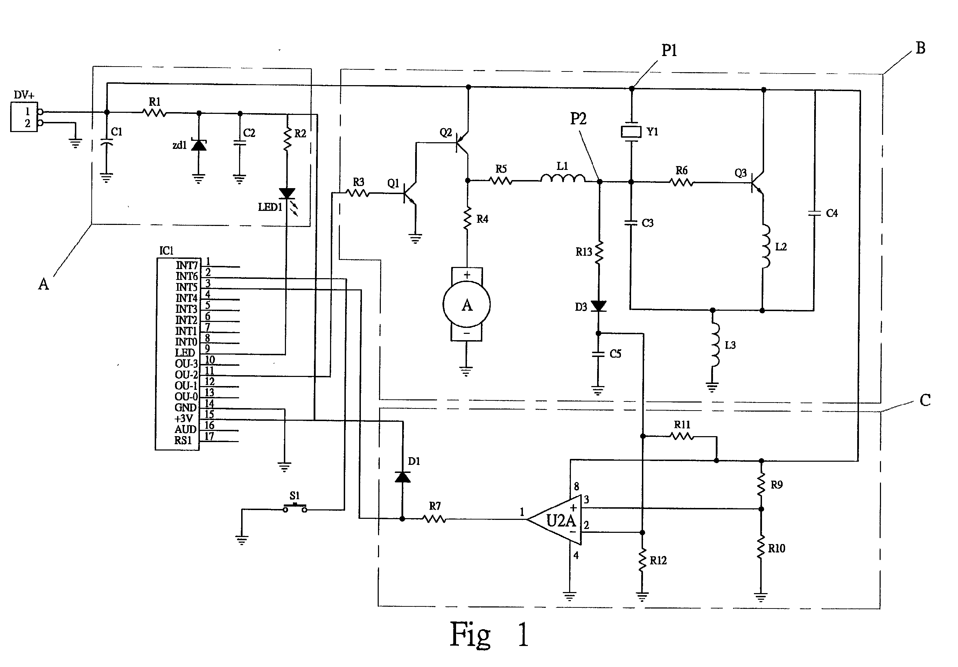

Figure 1 is a diagram of a protective circuit for a supersonic humidifier in the present invention.

### DETAILED DESCRIPTION OF THE PREFERRED EMBODIMENT

A preferred embodiment of a protective circuit for a supersonic humidifier in the present invention, as shown in Fig. 1, includes an input terminal of DCV power source, a voltage stabilizer circuit A connected to the input terminal, a drive circuit B of an oscillator continually connected to the voltage stabilizer A, an indicator L1, an oscillator Y1, a capacitor C3, and a resistor R6 contained in the drive circuit B, and a terminal P2 of the resistor R6 connected to a voltage dividing circuit which is connected to a compare circuit C. Another terminal P1 of the oscillator Y1 is also contained in the compare circuit C, and signals coming from the terminal P2 is received by a second pin 2 of an OP amplifier U2A, signals coming from the terminal P1 is received by a third pin 3 of the OP amplifier U2A.

In operation of the protective circuits, the oscillator Y1 operates normally in case the water level in the water tank of the humidifier is normal, so the working current, working voltage and oscillating frequency received by the terminal P2 is normal. In other words, the two values of the signal sources at the terminals p1 and P2 transmitted to the second and the third pin of the amplifier U2A are equal so no signal is sent out from the first pin of the OP amplifier U2A to an integrated circuit IC1. But provided that the water in the water tank is used up, the working current, the working voltage and the oscillating frequency may change, with each value changing larger or smaller than the normal value. Then signal sources of the terminals P2 and P1 may become unequal or excessive large, and the second pin 2 and the third pin 3 may have different input values, permitting the first pin 1 of the OP amplifier U2A may transmit a signal output to the IC1 to activate the drive circuit B of the oscillator Y1 to turn off the drive transistors Q1 and Q2, stopping both a fan and the oscillator Y1 so as to protect the humidifier.

While the preferred embodiment of the protective circuit for a supersonic humidifier has been described above, it will be recognized and understood that various modifications may be made therein and the appended claims are intended to cover all such modifications that may fall within the spirit and scope of the invention.

## Claims

1. A protective circuit for a supersonic humidifier comprising:
An input terminal of DC source:
A voltage stabilizer connected to said input terminal of DC source:
A drive circuit of an oscillator connected behind said voltage stabilizer and having a terminal P2 to form a signal dividing voltage circuit to be sent to a compare circuit and anther terminal P1 to transmit signals to said compare circuit:
Said compare circuit including an OP amplifier, which has a third pin receiving signal input from said terminal P2, and a second pin receiving signals from said first terminal: and,
Working current, working voltage and oscillating frequency of said oscillator immediately changing in case of no water left in a water tank of a supersonic humidifier, signal values of said terminal P2 and P1 then becoming different or changing excessively large so that said second and said third pin of said OP amplifier may have different input values, letting said first pin of said OP amplifier receive signal output to transmit to the subsequent circuit so as to stop operation of said drive circuit of said oscillator and protectively turn off said humidifier.
